Europäisches Patentamt

European Patent Office

Office européen des brevets

(11) Publication number: **0 092 330**
**B1**

(12) EUROPEAN PATENT SPECIFICATION

(45) Date of publication of patent specification: **10.01.90**

(51) Int. Cl.⁵: **G 01 B 11/00**

(21) Application number: **83301817.9**

(22) Date of filing: **30.03.83**

(54) Infra red photo detector systems.

(30) Priority: **19.04.82 GB 8211291**

(43) Date of publication of application:
**26.10.83 Bulletin 83/43**

(45) Publication of the grant of the patent:
**10.01.90 Bulletin 90/02**

(84) Designated Contracting States:
**DE FR GB NL**

(56) References cited:
**GB-A- 780 089**
**GB-A- 947 883**
**GB-A-1 542 679**
**GB-A-2 099 653**
**US-A-3 400 276**
**US-A-3 995 159**
**US-A-4 004 148**

(73) Proprietor: **The Secretary of State for Defence in Her Britannic Majesty's Government of the United Kingdom of Great Britain and Northern Ireland Whitehall London S.W.1. (GB)**

(72) Inventor: **Elliott, Charles Thomas**
**8 Hall Green**
**Malvern Worcestershire (GB)**
Inventor: **White, Anthony Michael**
**3 Guarlford Road**
**Malvern Worcestershire (GB)**

(74) Representative: **Edwards, John Brian et al Procurement Executive Ministry of Defence Patents 1 A (4), Room 2014 Empress State Building Lillie Road London SW6 1TR (GB)**

Courier Press, Leamington Spa, England.

## Description

This invention relates to infra red (I.R.) photo detector systems, using detectors that change their resistivity when illuminated by infra red radiation.

Photo detectors are used in a variety of infra red detection systems. For example burglar alarms where the body heat, of a person passing through a door, is focussed onto an infra red detector. The change in resistivity of the detector causes an alarm signal. Such a system senses only the near presence of a person or other hot object such as a fire. More elaborate systems may use an array of detectors to give an approximate position or direction of a hot object in accordance with the particular detector illuminated. Such systems are often termed staring arrays. The positional accuracy for determining hot objects is limited by the number and size of detectors. Using very large numbers of small detectors a reasonable image of a thermal scene is theoretically obtainable. However each detector is only capable of providing a signal representing average radiation received. It cannot distinguish between overall illumination and point illumination. Resolution is thus limited by detector size.

Highly detailed information of a thermal scene is obtainable using scanned imaging systems. In these an image of an infra red scene is scanned point by point on to one or more infra red detectors. The scanning is often by rotating polygons and oscillating mirrors, and the detectors cooled by liquid nitrogen.

The detector output may be viewed via a television monitor and is observed in detail similar to that from conventional television cameras. These systems give sufficient detail for example to detect human tumours by the temperature difference between healthy and tumerous tissues. The high performance is unnecessarily good for some applications, also the cost and mechanical complexity is high.

One form of infra red detector is disclosed in US Pat. No. 3,995,159, and a variant of this is disclosed in GB 2,019,649A. These relate to an integrating strip detector. Such a detector incorporates an elongate strip of infra red photoconductive material having a respective electrical bias contact at each end. Imaging means are provided to form an image of a thermal scene on the strip surface. Photocarriers produced by the image are swept along the length of the strip in a direction parallel to the surface on which the image is formed. The photocarriers are swept towards the output bias contact under the action of voltage applied across both bias contacts. Scanning means are employed to scan the image along the strip in the same direction and at the same rate as the photocarrier flow. As a result, each image element continues to produce photocarriers to augment those it produced earlier. This produces continuous integration of the signal from each scene element. Necessarily, imaging scanning and photocarrier drift must remain matched in magnitude and direction to ensure that dissimilar image elements do not contribute to like signal portions. The output signal from the strip is taken across a readout contact and the output bias contact, the readout contact being positioned close to the output contact and the strip length therebetween defining a readout region. The detected image may be measured as a bulk resistivity change in the readout region. Since photocarriers generated in the strip must flow towards the readout region, the strip is electrically unidirectional.

A further form of infra red detector is disclosed in US Pat. No. 4,004,148. It relates to an accumulation mode charge injection infra red sensor, i.e. a capacitive device. It comprises a silicon semiconductor substrate one surface of which bears thin insulating oxide layer ($SiO_2$). Electrical contacts are applied to the insulating layer and to the remote surface of the substrate. Consequently, the contacts are spaced by the combined substrate and layer thicknesses. The contacts are connected to a source of bi-directional pulses. Infra red light illuminates and is dispersed over the substrate surface, the light passing through the substrate's electrical contact which is transparent. The detector is operated at cryogenic temperatures (5—50 K) so that impurity states in the semiconductor substrate are neutral (un-ionised). When the detector is illuminated with infra red radiation, impurity states become ionised. A source of bi-directional electrical pulses is connected across the two contacts, ie. across the contact to the insulating oxide layer and the transparent contact to semiconductor substrate. A first pulse polarity drives charge created by illumination to the interface between the insulating layer and the semiconductor substrate. Charge therefore accumulates at this interface. The reverse polarity drives the accumulated charge to the transparent contact of the substrate for subsequent integration and amplification in an external circuit. Movement of charge is generally parallel to the thickness dimensions of the substrate and insulating layers, ie perpendicular to the plane of the infra red-illuminated surface of the transparent contact. A difference in output signal level from the external circuit for the two pulse polarities provides a measure of infra red illumination. However, there is no disclosure of any means for detecting the position of an image on the transparent contact.

The present invention provides greater image position information than is obtainable from known staring systems, and has reduced complexity as compared to known mechanical scanning systems.

The present invention provides a method of detecting the position of an infra red light source in a scene, the method including the steps of:

(a) imaging the scene on to a photosensitive surface region of an infra red photoconductive element, the element bearing bias electrodes to define a bias current path through the element substantially parallel to the surface region,

(b) applying an electrical bias across the electrodes, and

(c) detecting the element output signal with the aid of means responsive to element resistance change,

and wherein the method also includes the step of measuring the light source image position on the element from change in element resistance produced either by reversing the bias polarity or by moving the light source image position at least partly in a direction opposite to and at a rate slower than photocarrier flow.

The electrical bias may be DC and varied by polarity reversal. The image position may then be obtained from a difference/sum ratio of element resistances for the two bias polarities.

Alternatively, the bias may be AC with high frequency polarity reversal, the image position being detected by asymmetry in the element output signal arising from resistance variation with bias polarity. The asymmetry may be an offset asymmetry detected in magnitude and sign, and may be processed to provide an offset-counteracting DC bias feedback signal itself indicating image position.

In another embodiment of the invention, the electrical bias signal is DC, the image is scanned in a direction opposite to photocarrier flow and the image position is extracted from the time interval between a scan synchronisation pulse and receipt of an edge of a ramp signal output from the photoconductive element. The scan may be in a saw-tooth manner.

The photoconductive element material may be $Cd_xHg_{1-x}Te$, InSb or InAs, and the element may be cooled.

In another aspect, the invention also provides detector apparatus for performing the foregoing method, the apparatus including:

(a) an infra red photoconductive element having a photosensitive surface region,

(b) at least one pair of bias electrodes contacting the element and disposed to define at least one bias current path through the element substantially parallel to the surface region,

(c) infra red imaging means arranged to form an image of a scene containing an infra red light source on the surface region,

(d) biasing means arranged to provide element bias current to the electrodes, and

(e) detecting means responsive to element resistance change,

and wherein the apparatus also includes element resistance varying means comprising either means for reversing the bias current polarity or means adapted to move the imaged light source position on the surface ergion at least partly in a direction opposite to and at a rate slower than photocarrier flow, whereby in operation the detecting means provides an element resistance change indication of infra red light source image position.

The bias reversing means may be arranged to operate at high frequency. Alternatively, the imaged light source position may be moved by means adapted to cause it to precess or wobble on the element surface region.

The photoconductive element may have a plurality of opposed pairs of bias electrodes regularly spaced around the photosensitive region and biasing means for biasing successive electrode pairs. Such an element is employed either with bias reversing means or with image movement means and means for indicating image position from element resistance change in response to bias reversal or image movement.

The invention will now be described, by way of example only, with reference to the accompanying drawings, in which:

Figure 1 is a view of an infra red detector system that can operate in a staring or a swept mode;

Figure 2 is a circuit diagram showing the detector of Figure 1 connected in a bridge network;

Figures 3 and 4 are graphs showing the output of the bridge for positive and negative bias applied to the detector of Figure 1 as a function of the position of a small spot of illumination;

Figure 5 is a graph showing the bridge output when a spot of infra red radiation is scanned repetitively along the detector;

Figures 6 and 7 are views of detectors having a plurality of electrodes so that azimuth and elevation positional information is obtainable;

Figure 8 is a plan view of a detector showing contours of constant sensitivity for a field applied between opposing parallel electrodes.

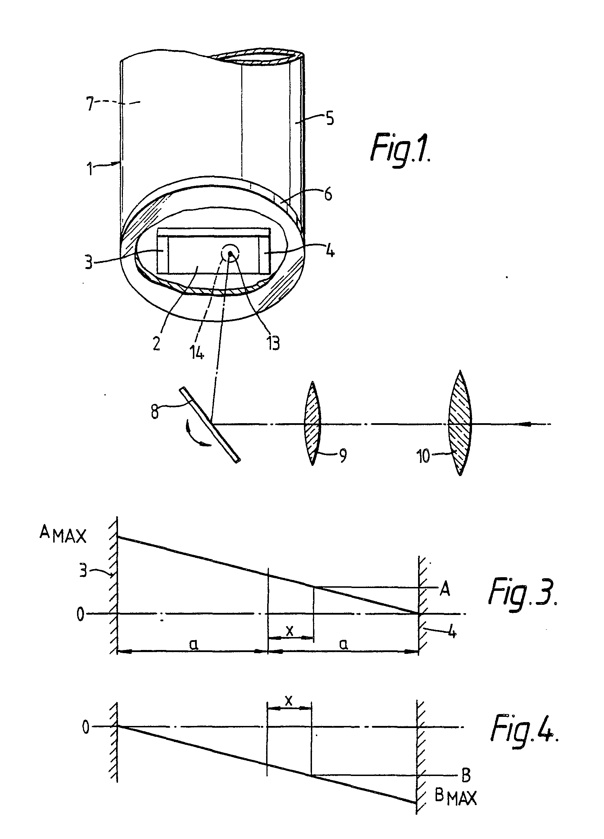

As seen in Figure 1 a detector system 1 comprises a piece of infra red detector material 2 such as the ternary alloy $Cd_xHg_{1-x}Te$. Typical dimensions are 100 $\mu m^2$. Strip electrodes 3, 4 are attached along two opposite edges of the detector material 2. The detector 2, 3, 4 is mounted inside an evacuated envelope 5 above an infra red transparent window 6 e.g. of germanium and cooled by liquid nitrogen 7.

A mirror 8 and lenses 9, 10 direct infra red radiation onto the detector material 2. The mirror 8 may be fixed, or oscillated as described later.

The detector of Figure 1 is connected in a bridge network 11 as shown in Figure 2. This bridge 11 comprises two fixed resistors $R_1$, $R_2$, and a variable resistor $R_3$ for balancing. Input to the bridge 11, either D.C. or A.C. is from a voltage supply 12.

When a spot area 13 of the detector 2 is illuminated with infra red radiation photo carriers are generated. Let the detector length between electrodes 3, 4, be 2a and the position of the illuminated spot measured from the centre be x, Figures 3, 4. For n-type material with a carrier concentration of about $5 \times 10^{14}$ $cm^{-3}$ applying a positive voltage to electrode 3 causes a photo carrier drift to the right. When the applied field is sufficiently high e.g. 30 volts/cm the minority carriers are swept towards the earth contact 4, where they recombine. For steady state conditions the change of resistance between electrodes 3, 4 is proportional to the distance photo carriers drift before recombining. The part of detector material carrying the drifting carriers is of reduced resistance compared to the remainder of the detector material. Figure 3 shows the resistance change between electrodes 3, 4 for varying values of x, the position of constant spot 13 illumination. At the right hand edge carriers recombine into electrode 4 as they are formed, i.e. zero drift path length, and so the resistance change developed is zero. At the left hand edge the carriers drift the whole length of detector, i.e. drift path length is 2a, and the resistance change between electrodes 3, 4 is at a maximum value of $A_{MAX}$.

Similarly when a negative potential is applied to electrode 3 the carriers drift to the left Figure 4. The minimum resistance change, developed occurs when the illuminating spot 13 is by the left hand electrode 3, and the maximum resistance change $B_{MAX}$ occurs when the spot 13 is near the right hand electrode 4.

The position x, along the detector 2 of illuminating spot 13 as determined by measuring A, B, as follows:

$$A=k(a-x),$$

k is proportional to the illumination intensity

$$-B=k(-a-x)$$

$$x=\frac{a(B-A)}{B+A}.$$

A and B are regarded as positive quantities.

For example if the change in the negative direction, equals the change in the positive direction (B=A) then x=0, the centre.

Thus by applying first a positive potential and then a negative potential to electrode 3 the position of the illuminating spot 13 is obtained. For example the position of 5 μm diameter spot along a 50 μm length is obtained.

The responses shown in Figures 3, 4 are idealised. In practice the curves are not quite linear in the centre region and may differ considerably near the contacts 3, 4. Corrections for these variations may be allowed for using a look up table e.g. using a programmed read only memory (PROM).

The bridge of Figure 2 may be adjusted to give zero output for zero point illumination, or zero uniform illumination. When balanced for zero illumination, uniform illumination over the complete detector from background radiation will give A=B corresponding to an apparent x=0. When balanced for uniform background illumination A=B=0. Deviation of background will cause a spurious signal corresponding to an apparent target at x=0 because the equations for x above do not apply to uniform illumination. Thus continuous monitoring of background is desirable and the bridge balanced accordingly.

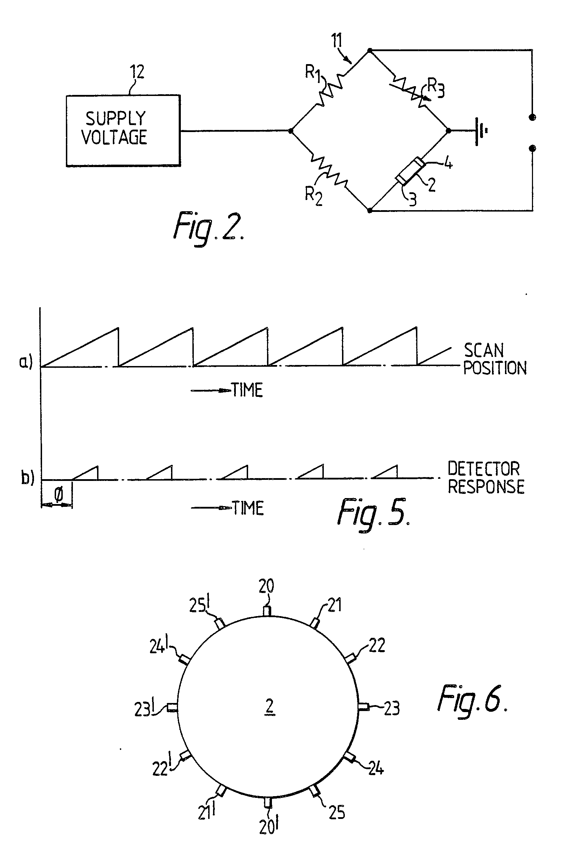

The effect of background illumination and bias pedestal can be removed by scanning the spot 13 along the detector 2 with the mirror 8. Figures 5a shows a graph of mirror 8 position which is caused by scan in a saw-toothed manner. As the mirror scans it sweeps a spot 13 of infra red radiation along the detector 2 in a direction opposite to photo carrier drift. This results in a ramp response on the bridge output as shown in Figure 5b. The position of this ramp signal within each scan represents the angular position of the target forming the spot 13 relative to the scan extreme positions. The length of the ramp signal is a function of detector length and system optics. Target angular position is thus determined by a timing circuit which times the interval $\Phi$ between a synchronisation pulse at the beginning of each scan and receipt of the ramp signal (leading or trailing edge).

The above arrangement can be extended to determine the angular position of a plurality of infra red sources. Each source will be detected as a ramp voltage by the bridge.

In an alternative arrangement the mirror 8 is caused to precess or wobble so that a spot 13 moves in a small circle on the detector 2. This gives a bridge output signal

$$dA=kdx.$$

The mean signal intensity is

$$A=k(a-x)$$

from which x is extracted. The modulation dA is insensitive to background or bias pedestal.

In both the scanning and wobbling system the mirror movement is slow in comparison with carrier drift velocity. For example carrier lifetime may be 1 to 10 μs, drift velocity $5\times10^3$ to $5\times10^4$ cm/s depending on bias pedestal 2 to 20 mA, scan velocity 1/10×drift velocity, modulation velocity 1/10 drift velocity.

Another form of the invention uses a high frequency bias applied by the voltage supply 12. This is arranged such that:

frequency $f \gtrsim \mu E/2a$

$\mu$ is typically 300 cm²/Vs.

E is peak field

2a is distance between contacts 3, 4.

With such a high frequency bias carriers are not swept out within each half cycle but are swept alternately towards contacts 3, 4 on alternate half cycles and reach the contacts 3, 4 by diffusion.

For a spot 13 in the centre of the detector 2 carriers reach both contacts 3, 4 equally by diffusion. When the spot 13 is displaced away from the centre then carriers are preferentially lost at the nearest contact. This leads to an asymmetry in the output (A.C.) signal at the electrodes 3, 4. The amount and direction of A.C. offset indicates spot position x on the detector 2, and the A.C. value indicates spot 13 intensity.

Alternatively the A.C. offset may be adjusted to zero by applying a D.C. bias feedback to the voltage supply 12. This optimises sensitivity by maximising carrier life time over complete cycles. The spot position is related to the amount of D.C.

bias applied.

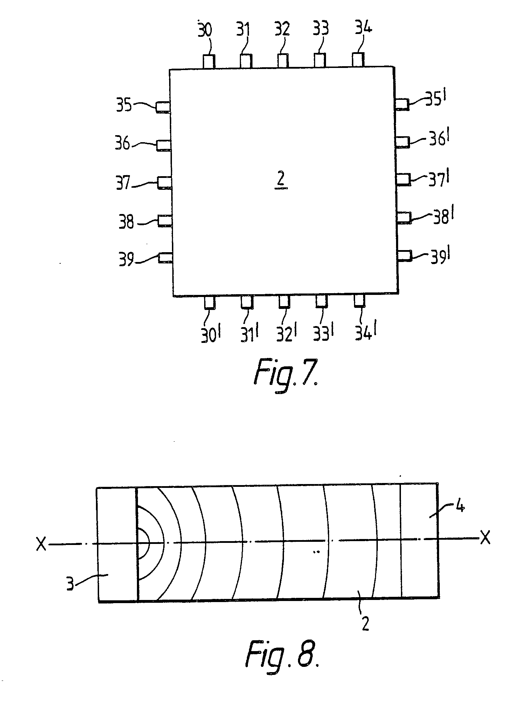

The above systems provide only positional information x. To provide both azimuth and elevation position the detector may be provided with a plurality of opposed electrode pairs as shown in Figures 6, 7.

In Figure 6 a detector 2 is arranged as a disc with discrete pairs of opposing electrodes 20, 20' to 25, 25'. Similarly a square shaped detector 2 (Figure 7) has discrete opposing electrodes 30, 30' to 34, 34' and 35, 35' to 39, 39'.

Each opposing electrode e.g. 20, 20' is connected in sequence into a bridge 11 whilst the remaining contacts remain disconnected, at a floating potential. Treating the information from each pair of contacts as previously described indicates both r, and θ information in Figure 6. To obtain x, information in Figure 7 bias is applied between electrodes 30—34 and 30'—34' and measurements proceed as in Figure 1, electrodes 35—39 and 35'—39' remain unconnected.

Similarly to obtain y information bias is applied between electrodes 35—39 and electrodes 35'—39' whilst electrodes 30—34 and 30'—34' are unconnected.

Another method of determining x, y uses the arrangement of Figure 1. The effect of applying bias to electrodes 3, 4 is to produce in the detector 2 variations in sensitivity as shown in Figure 8 which indicates contours of constant sensitivity. As shown these increase towards electrodes 3 but reverse with reverse applied bias. The contours are symmetric about a lengthwise axis X X.

The mirror 8 is caused to wobble thus sweeping a spot 13 of radiation in a circle 14. The effect of sweeping the spot 13 in a circle is to cause a periodic fluctuation in the detector response as measured at the electrodes 3, 4. For a spot along the line XX the maximum response occurs when the spot is nearest electrode 3. This position may be taken as a zero phase position of the mirror 8. For spot 13 incident on the detector 2 above or below the line XX the maximum detector response occurs where the circles 14 tangent is parallel to a contour line and nearest to electrode 3. This maximum response occurs at some mirror phase angle $\pm\phi$. The measurement of x and $\phi$ uniquely indicates the position of a circle 14 (spot 13) on the detector 2. Thus information on x and $\phi$ may be fed into a look-up table formed in a random access read only memory RAROM. The resultant output is thus the x, y position of a spot 13 on the detector 2.

## Claims

1. A method of detecting the position of an infra red light source in a scene, the method including the steps of:

(a) imaging the scene on to a photosensitive surface region of an infra red photoconductive element (2), the element (2) bearing bias electrodes (3, 4) to define a bias current path through the element (2) substantially parallel to the surface region,

(b) applying an electrical bias across the electrodes (3, 4), and

(c) detecting the element output signal with the aid of means ($R_1$, $R_2$, $R_3$, 2, 12) responsive to element resistance change.

and wherein the method also includes the step of measuring the light source image position (13) on the element (2) from change in element resistance produced either by reversing the bias polarity or by moving the light source image position (13) at least partly in a direction opposite to and at a rate slower than photocarrier flow.

2. A method according to Claim 1, characterised in that the electrical bias is DC and is varied by polarity reversal, and the light source image position (13) is derived from a difference/sum ratio of element resistances for the two bias polarities.

3. A method according to Claim 1 characterised in that the bias polarity is reversed at a high frequency, and the light source image position (13) is extracted from asymmetry in the element output signal arising from differing photocarrier drift path lengths under positive and negative bias conditions.

4. A method according to Claim 3 characterised in that the light source image position (13) is detected from offset asymmetry in the element output signal, the offset being detected in magnitude and sign.

5. A method according to Claim 4 characterised in that the offset is processed to provide an offset-counteracting DC bias feedback signal, the feedback signal being detected to indicate light source image position (13).

6. A method according to Claim 1 characterised in that the electrical bias signal is DC, the imaged scene is moved in a direction opposite to photocarrier flow, and the light source image position (13) is extracted by measuring the interval ($\Phi$) between a scan synchronisation signal and receipt of an edge of a ramp signal output from the element (2).

7. A method according to Claim 6 characterised in that the image position (13) is moved and returned to a saw-tooth manner.

8. A method according to Claim 1 characterised in that the means ($R_1$, $R_2$, $R_3$, 2, 12) responsive to element resistance change is a bridge circuit (11) in which the element (2) is arranged as one arm, the bridge (11) having a variable resistor ($R_3$) as a further arm, the bridge (11) is balanced by adjusting the variable resistor ($R_3$), the bias polarity is varied by reversal, and the light source image position (13) is measured from a difference/sum ratio of element resistances for the two bias polarities.

9. A method according to Claim 1 characterised in that it is performed with an element (2) made from $Cd_xHg_{1-x}Te$, InSb or InAs.

10. Detector apparatus for performing the method of Claim 1, and which comprises:

(a) an infra red photoconductive element (2) having a photosensitive surface region,

(b) at least one pair of bias electrodes (3, 4) contacting the element (2) and disposed to define at least one bias current path through the element (2) substantially parallel to the surface region,

(c) infra red imaging means (9, 10) arranged to form an image of a scene containing an infra red light source on the surface region,

(d) biasing means (12) arranged to provide element bias current to the electrodes (3,4), and

(e) detecting means ($R_1$, $R_2$, $R_3$, 2, 12) responsive to element resistance change,

and wherein the apparatus also includes element resistance varying means comprising either means for reversing the bias current polarity or means (8) adapted to move the imaged infra red light source position (13) on the surface region at least partly in a direction opposite to and a rate slower than photocarrier flow, whereby in operation the detecting means ($R_1$, $R_2$, $R_3$, 2, 12) provides an element resistance change indication of infra red light source image position (13).

11. Detector apparatus according to Claim 10 characterised in that the means for reversing bias polarity is arranged for high frequency bias reversal.

12. Detector apparatus according to Claim 10 characterised in that the means (8) for moving the imaged infra red light source position (13) is arranged to cause image precession or wobbling.

13. Detector apparatus according to Claim 10 characterised in that the said at least one pair of bias electrodes comprises a plurality of opposed pairs of bias electrodes (20/20' to 25/25', 30/30' to 39/39') regularly spaced around the photosensitive surface region, and the biasing means is arranged to bias the opposed pairs of electrodes (eg. 20/20', 30/30') in succession.

**Patentansprüche**

1. Verfahren zur Erkennung der Position einer Infrarot-Lichtquelle in einem Bild, wobei das Verfahren die Schritte

(a) des Abbildens des Bildes auf den fotoempfindlichen Oberflächenbereich eines infrarotfotoleitenden Elementes (2), welches Vorspannungselektroden (3, 4) enthält, die einen zum Oberflächenbereich im wesentlichen parallelen Vorspannungsstrompfad durch das Element (2) definieren,

(b) des Anlegens einer elektrischen Vorspannung an die Elektroden (3, 4), und

(c) des Erkennens des Elementausgangssignals mit Hilfe einer Einrichtung ($R_1$, $R_2$, $R_3$, 2, 12), die auf Widerstandsänderungen des Elementes anspricht, aufweist,

und wobei das Verfahren außerdem den Schritt des Ausmessens der Lichtquellen-Abbildungsposition (13) auf dem Element (2) aus der Änderung des Elementwiderstandes, der entweder durch Umkehrung der Vorspannungspolarität oder durch Bewegen der Lichtquellen-Abbildungsposition (13) wenigstens zum Teil in einer den Fototrägerfluß entgegengesetzten Richtung und mit einer niedrigeren Geschwindigkeit als dieser erzeugt wird, enthält.

2. Verfahren gemäß Anspruch 1, dadurch gekennzeichnet, daß die elektrische Vorspannung eine Gleichspannung ist und durch Polaritätsumkehr verändert wird und daß die Lichtquellen-Abbildungsposition (13) aus einem Differenz-/Summenverhältnis der Elementwiderstände der zwei Vorspannungspolaritäten abgeleitet wird.

3. Verfahren gemäß Anspruch 1, dadurch gekennzeichnet, daß die Vorspannungspolarität mit hoher Frequenz umgekehrt wird und daß die Lichtquellen-Abbildungsposition (13) aus der Asymmetrie im Elementausgangssignal gewonnen wird, die aus unterschiedlichen Fototräger-Driftweglängen bei positiven und negativen Vorspannungsbedingungen entsteht.

4. Verfahren gemäß Anspruch 3, dadurch gekennzeichnet, daß die Lichtquellen-Abbildungsposition (13) aus der Offsetasymmetrie im Elementausgangssignal erkannt wird, wobei der Offset nach Größe und Vorzeichen erkannt wird.

5. Verfahren gemäß Anspruch 4, dadurch gekennzeichnet, daß der Offset ausgewertet wird, um ein dem Offset entgegenwirkendes Gleichstromvorspannungsrückkopplungssignal zu erzeugen, wobei das Rückkopplungssignal ermittelt wird, um die Lichtquellen-Abbildungsposition (13) anzuzeigen.

6. Verfahren gemäß Anspruch 1, dadurch gekennzeichnet, daß das elektrische Vorspannungssignal ein Gleichspannungssignal ist, das abgebildete Bild in einer dem Fototrägerfluß entgegengesetzten Richtung bewegt wird und die Lichtquellen-Abbildungsposition (13) durch Ausmessen des Intervalls (φ) zwischen einem Abtastsynchronisationssignal und dem Empfang einer Flanke einer Sägezahnsignalausgabe des Elementes (2) gewonnen wird.

7. Verfahren gemäß Anspruch 6, dadurch gekennzeichnet, daß die Abbildungsposition (13) entsprechend einem Sägezahnverlauf hin- und herbewegt wird.

8. Verfahren gemäß Anspruch 1, dadurch gekennzeichnet, daß die auf die Elementwiderstandsänderung ansprechende Einrichtung ($R_1$, $R_2$, $R_3$, 2, 12) eine Brückenschaltung (11) ist, in der das Element (2) als ein Zweig angeordnet ist, wobei die Brücke (11) einen variablen Widerstand ($R_3$) als wieteren Zweig aufweist, wobei die Brücke (11) durch Einstellung des variablen Widerstandes ($R_3$) abgeglichen wird, wobei die Vorspannungspolarität durch Umkehrung variiert wird und wobei die Lichtquellen-Abbildungsposition (13) aus dem Differenz-/Summenverhältnis des Elementwiderstände für die zwei Vorspannungspolaritäten ausgemessen wird.

9. Verfahren gemäß Anspruch 1, dadurch gekennzeichnet, daß es mit einem Element (2) ausgeführt wird, das aus $Cd_xHg_{1-x}Te$, aus InSb oder aus InAs hergestellt ist.

10. Detektorvorrichtung zum Ausführen des Verfahrens gemäß Anspruch 1, mit

(a) einem infrarotfotoleitenden Element (2), das einen fotoempfindlichen Oberflächenbereich aufweist;

(b) wenigstens einem Paar von Vorspannungselektroden (3, 4), die das Element (2) kontaktieren und so angeordnet sind, daß sie durch das Element (2) wenigstens einem zum Oberflächenbereich im wesentlichen parallelen Vorspannungsstrompfad definieren;

(c) einer Infrarot-Abbildungseinrichtung (9, 10), die so angeordnet ist, daß sie auf dem Oberflächenbereich von einem eine Infrarot-Lichtquelle enthaltenden Bild ein Abbild herstellt;

(d) einer Vorspannungseinrichtung (12), die so angeordnet ist, daß sie für die Elektroden (3, 4) einen Element-Vorspannungsstrom erzeugt; und

(e) einer Erkennungseinrichtung ($R_1$, $R_2$, $R_3$, 2, 12), die auf eine Elementwiderstandsänderung anspricht,

wobei die Vorrichtung außerdem eine Einrichtung zum Verändern des Elementwiderstandes enthält, die entweder eine Einrichtung zum Umkehren der Vorspannungsstrompolarität oder eine Einrichtung (8), die so ausgebildet ist, daß sie die auf dem Oberflächenbereich abgebildete Infrarot-Lichtquellenposition (13) wenigstens zum Teil in einer dem Fototrägerfluß entgegengesetzten Richtung und mit einer niedrigeren Geschwindigkeit als dieser bewegt, aufweist, wobei die Erkennungseinrichtung ($R_1$, $R_2$, $R_3$, 2, 12) im Betrieb eine Elementwiderstandsänderungsanzeige der Infrarotlichtquellen-Abbildungsposition (13) darstellt.

11. Detektorvorrichtung gemäß Anspruch 10, dadurch gekennzeichnet, daß die Einrichtung zum Umkehren der Vorspannungspolarität für Hochfrequenzvorspannungsumkehr ausgelegt ist.

12. Detektorvorrichtung gemäß Anspruch 10, dadurch gekennzeichnet, daß die Einrichtung (8) zum Bewegen der abgebildeten Infrarotlichtquellenposition (13) so ausgebildet ist, daß sie eine Präzession oder ein Wobbeln des Bildes bewirkt.

13. Detektorvorrichtung gemäß Anspruch 10, dadurch gekennzeichnet, daß das wenigstens eine Paar von Vorspannungselektroden eine Mehrzahl von entgegengesetzten Paaren von Vorspannungselektroden (20/20' bis 25/25', 30/30' bis 39/39') aufweist, die in gleichem Abstand um den fotoempfindlichen Oberflächenbereich angeordnet sind, und daß die Vorspannungseinrichtung so angeordnet ist, daß sie die entgegengesetzten Elektrodenpaare (z.B. 20/20', 30/30') nacheinander vorspannt.

**Revendications**

1. Procédé de détection de la position d'une source infrarouge dans une scène, le procédé comprenant les étapes suivantes:

(a) la formation d'une image de la scène sur une région superficielle photosensible d'un élément photoconducteur infrarouge (2), l'élément (2) portant des électrodes de polarisation (3, 4) destinées à délimiter un trajet de circulation d'un courant de polarisation dans l'élément (2) en direction sensiblement parallèle à la région superficielle,

(b) l'application d'une polarisation électrique aux électrodes (3, 4), et

(c) la détection du signal de sortie de l'élément à l'aide d'un dispositif ($R_1$, $R_2$, $R_3$, 2, 12) sensible à la variation de résistance de l'élément, et

le procédé comporte aussi la mesure de la position (13) de l'image de la source lumineuse sur l'élément (2) à partir du changement de résistance de l'élément produit soit par inversion de la polarité de la polarisation soit par déplacement de la position (13) de l'image de la source lumineuse au moins partiellement en sens opposé à celui du courant des photoporteurs et à une vitesse inférieure à celle de ce courant.

2. Procédé selon la revendication 1, caractérisé en ce que la polarisation électrique est en courant continu et est modifiée par inversion de polarité, et la position (13) de l'image de la source lumineuse est dérivée du rapport de la différence et de la somme des résistances de l'élément pour les deux polarités de polarisation.

3. Procédé selon la revendication 1, caractérisé en ce que la polarité de polarisation est inversée à haute fréquence, et la position (13) de l'image de la source lumineuse est extraite d'après l'asymétrie du signal de sortie de l'élément, due aux longueurs différentes de trajet de dérive des photoporteurs dans les conditions de polarisation positive et négative.

4. Procédé selon la revendication 3, caractérisé en ce que la position (13) de l'image de la source lumineuse est détectée de l'asymétrie du décalage du signal de sortie de l'élément, le décalage étant détecté en amplitude et en signe.

5. Procédé selon la revendication 4, caractérisé en ce que le décalage est traité afin qu'il donne un signal de rétroaction à polarisation en courant continu compensant le décalage, le signal de rétroaction étant détecté afin qu'il indique la position (13) de l'image de la source lumineuse.

6. Procédé selon la revendication 1, caractérisé en ce que le signal de polarisation électrique est en courant continu, la scène formant l'image est déplacée en sens opposé aà celui du courant des photoporteurs, et la position (13) de l'image de la source lumineuse est extraite par mesure de l'intervalle ($\Phi$) compris entre le signal de synchronisation de balayage et la réception d'un flanc d'un signal de sortie variant progressivement, provenant de l'élément (2).

7. Procédé selon la revendication 6, caractérisé en ce que la position de l'image (13) est déplacée et ramenée en dents de scie.

8. Procédé selon la revendication 1, caractérisé en ce que le dispositif ($R_1$, $R_2$, $R_3$, 2, 12) sensible au changement de résistance de l'élément est un circuit en pont (11) dans lequel l'élément (2) est placé dans une branche, le pont (11) ayant une résistance variable ($R_3$) dans une autre branche, le pont (11) est équilibré par ajustement de la résistance variable ($R_3$), la polarité de polarisation est modifiée par inversion, et la position (13) de l'image de la source lumineuse est mesurée d'après le rapport entre la différence et la somme des résistances de l'élément pour les deux polarités de polarisation.

9. Procédé selon la revendication 1, caractérisé en ce qu'il est réalisé avec un élément (2) formé

de $Cd_xHg_{1-x}Te$, InSb ou InAs.

10. Appareil détecteur destiné à la mise en oeuvre du procédé selon la revendication 1, et qui comprend:

(a) un élément photoconducteur infrarouge (2) ayant une région superficielle photosensible,

(b) au moins une paire d'électrodes de polarisation (3, 4) qui est au contact de l'élément (2) et qui est destinée à délimiter au moins un trajet pour un courant de polarisation, dans l'élément (2), en direction sensiblement parallèle à la région superficielle,

(c) un dispositif (9, 10) de formation d'une image infrarouge d'une scène contenant une source lumineuse infrarouge, sur la région superficielle,

(d) un dispositif de polarisation (12) destiné à transmettre un courant de polarisation de l'élément aux électrodes (3, 4), et

(e) un dispositif de détection ($R_1$, $R_2$, $R_3$, 2, 12) sensible à un changement de résistance de l'élément, et

l'appareil comporte aussi un dispositif destiné à faire varier la résistance de l'élément et comportant soit un dispositif destiné à inverser la polarité du courant de polarisation, soit un dispositif (8) destiné à déplacer la position (13) de la source lumineuse infrarouge formant l'image sur la région superficielle au moins partiellement en sens opposé à celui du courant des photoporteurs et à une vitesse plus faible que celle de ce courant, si bien que, pendant le fonctionnement, le dispositif de détection ($R_1$, $R_2$, $R_3$, 2, 12) donne une indication, sous forme d'un changement de résistance de l'élément, sur la position (13) de l'image de la source lumineuse infrarouge.

11. Appareil détecteur selon la revendication 10, caractérisé en ce que le dispositif destiné à inverser la polarité de polarisation est destiné à assurer cette inversion à haute fréquence.

12. Appareil détecteur selon la revendication 10, caractérisé en ce que le dispositif (8) destiné à déplacer la position (13) de la source lumineuse infrarouge formant l'image est destiné à provoquer une précession ou une oscillation de l'image.

13. Appareil détecteur selon la revendication 10, caractérisé en ce que ladite paire d'électrodes de polarisation au moins comporte plusieurs paires opposées d'électrodes de polarisation (20/20' à 25/25', 30/30' à 39/39') régulièrement espacées autour de la région superficielle photosensible, et le dispositif de polarisation est destiné à polariser les paires opposées d'électrodes (par exemple 20, 20'; 30, 30') successivement.

Fig.1.

Fig.3.

Fig.4.

1

Fig.2.

Fig.5.

Fig.6.

30  31  32  33  34

<u>2</u>

35  35¹
36  36¹
37  37¹
38  38¹
39  39¹

30¹  31¹  32¹  33¹  34¹

*Fig.7.*

X —————————————— X

4

3

2

*Fig.8.*